(19) Europäisches Patentamt
European Patent Office
Office européen des brevets

(11) Publication number: 0 313 401
A2

(12) # EUROPEAN PATENT APPLICATION

(21) Application number: 88309949.1

(22) Date of filing: 21.10.88

(51) Int. Cl.$^4$: H 01 L 23/28
H 01 L 23/54

(30) Priority: 23.10.87 JP 268947/87

(43) Date of publication of application:
26.04.89 Bulletin 89/17

(84) Designated Contracting States: DE FR GB

(71) Applicant: Hitachi Chemical Co., Ltd.
1-1, Nishi-shinjuku 2-chome Shinjuku-ku
Tokyo 160 (JP)

(72) Inventor: Sekine, Hiroyoshi
3-B202, Nishinarusawacho-3-chome
Hitachi-shi (JP)

Suzuki, Hiroshi
12-4, Takasuzucho-5-chome
Hitachi-shi (JP)

(74) Representative: Cresswell, Thomas Anthony et al
J.A. Kemp & Co. 14 South Square Gray's Inn
London WC1R 5EU (GB)

(54) **Composition for semiconductor element protective film.**

(57) A composition comprising a polyamide-acid, an organic polar solvent and a special ketone as a solvent is suitable for forming a protective film or semiconductor elements and excellent in wetting and spreading properties with excellent adhesiveness.

EP 0 313 401 A2

**Description**

## COMPOSITION FOR SEMICONDUCTOR ELEMENT PROTECTIVE FILM

### BACKGROUND OF THE INVENTION

This invention relates to a composition for forming a protective film of semiconductor element excellent in wetting and spreading properties and capable of preventing soft errors caused by alpha rays.

In order to prevent semiconductor elements such as MOS memories, CCD, etc. from soft errors caused by alpha rays, there have been used polyimide precursor resin compositions containing no radioactive elements such as uranium, thorium, etc. which are sources of alpha rays and excellent in alpha rays shielding ability for forming a protective film. Recently, with higher integration of semiconductors, element areas are also enlarged. Since known polyimide precursor resin compositions are not so good in wetting and spreading properties (or wettability), it is difficult to cover the whole area of an element with a protective film having a uniform film thickness by a potting method. Further, there arises a pealing phenomenon at interface portions of the semiconductor element and the polyimide protective film by thermal stress. Thus, there is a defect in that alpha rays easily penetrate into a memory cell in the semiconductor element to generate soft errors.

In order to improve wettability of polyimide precursor resin compositions, there have been proposed various methods.

One example of such methods is to reduce a viscosity of polyamide-acid as low as possible. But there is a fear of flowing out the polyamide-acid which has been coated on a semiconductor element. Thus, there is a limit in this method.

Another example of such methods is to increase the amount of polyamide-acid coated on a semiconductor element. But this method also has defects in that the polyamide-acid coated on a semiconductor element also flows out, cracks are generated on a semiconductor element by thermal stress during heat treatment due to thick protective film, metallic fine wires are broken at bonding pat portion, the resulting polyimide film is pealed off from the surface of semiconductor element, and the like.

A further example of such methods is to use a solvent having low surface tension in the production of polyamide-acid. But this method has defects in that storage stability of a polyimide precursor resin composition becomes poor depending on solvents used or mixing proportions of solvent compositions, and sometimes causing gelation, or clouding due to lowering of solubility of the polyimide precursor.

A still further example of such methods is to add a surface active agent to a polyamide-acid solution (Japanese Patent Unexamined Publication No. 61-26248). But this method has defects in that adhesive strength of a polyimide protective film is remarkably lowered due to the addition of surface active agent to bring about pealing of the polyimide film from the surface of semiconductor element, polyamide-acid is clouded in the solution when too much surface active agent is added.

### SUMMARY OF THE INVENTION

It is an object of the present invention to provide a composition for forming a protective film of semiconductor element overcoming the defects of prior art techniques, excellent in adhesiveness and wettability, and suitable for forming a polyimide film on a semiconductor element by a potting method to prevent soft errors caused by alpha rays.

This invention provides a composition for forming a protective film of semiconductor element comprising

(i) a polyamide-acid obtained from a tetracarboxylic acid dianhydride and a diamine,

(ii-a) an organic polar solvent, and (ii-b) as an organic solvent, a ketone of the formula:

$$R_1 - \overset{\overset{\displaystyle O}{\|}}{C} - R_2 \qquad (I)$$

wherein $R_1$ and $R_2$ are independently an alkyl group having 1 to 8 carbon atoms.

### DESCRIPTION OF THE PREFERRED EMBODIMENTS

The polyamide-acid (i) can be obtained from a tetracarboxylic acid dianhydride and a diamine.

As the tetracarboxylic acid dianhydride, there can be used aromatic compounds such as pyromellitic dianhydride, 3,3′,4,4′-biphenyl tetracarboxylic dianhydride, 3,3′,4,4′-benzophenone tetracarboxylic dianhydride, cyclopentane tetracarboxylic dianhydride, 1,2,5,6-naphthalene tetracarboxylic dianhydride, 2,3,6,7-naphthalene tetracarboxylic dianhydride, 2,3,5,6-pyridine tetracarboxylic dianhydride, 1,4,5,8-naphthalene tetracarboxylic dianhydride, 3,4,9,10-perylene tetracarboxylic dianhydride, 2,2′,3,3′-biphenyl tetracarboxylic dianhydride, thiophene-2,3,4,5-tetracarboxylic dianhydride, etc.; aliphatic compounds such as ethylenebistrimellitic dianhydride, etc. These compounds can be used alone or as a mixture thereof.

As the diamine, there can be used m-phenylenediamine, p-phenylenediamine, m-xylenediamine, p-xylenediamine, 4,4′-diaminodiphenyl ether, 4,4′-diaminodiphenylmethane, 3,3′-dimethyl-4,4′-diaminodiphenylmethane, 3,3′,5,5′-tetramethyl-4,4′-diaminodiphenylmethane, 2,2′-bis[4-(4-aminophenoxy)phenyl]propane, 4,4′-methylenedianiline, benzidine, 4,4′-diaminodiphenylsulfide, 4,4′-diaminodiphenylsulfone, 1,5-diaminonaphthalene, 3,3′-dimethylbenzidine, 3,3′-dimethoxybenzidine, etc. These compounds can be used alone or as a mixture thereof.

In order to improve the adhesiveness to a semiconductor element, it is possible to use as a diamine component a diaminosiloxane represented by the formula:

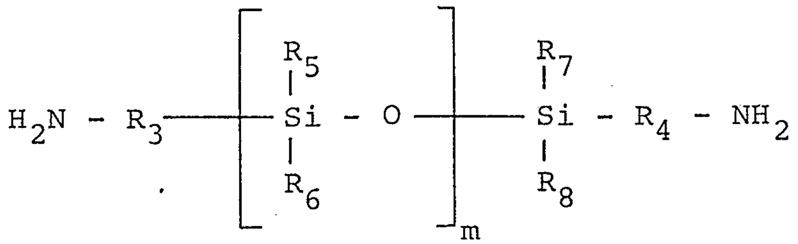

(II)

wherein $R_3$ and $R_4$ are a bivalent hydrocarbon group such as an alkylene group preferably having 1 to 5 carbon atoms, a phenylene group, etc.; $R_5$, $R_6$, $R_7$ and $R_8$ are independently a monovalent hydrocarbon group such as an alkyl group preferably having 1 to 5 carbon atoms, a phenyl group, etc.; and m is an integer of 1 or more, preferably 1 to 10.

Examples of the formula (II) are as follows:

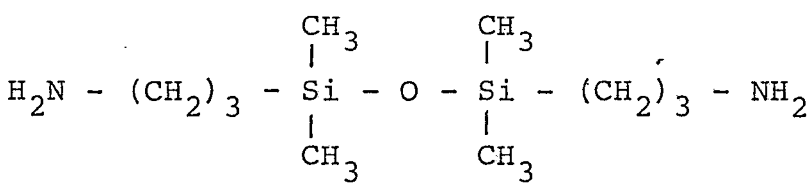

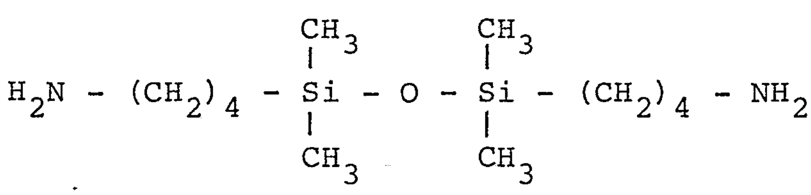

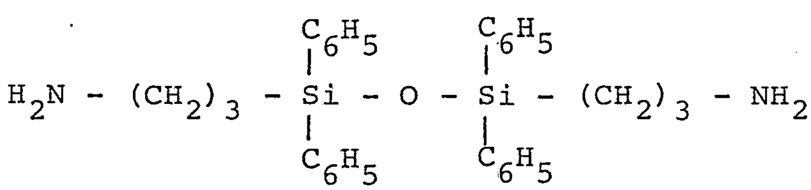

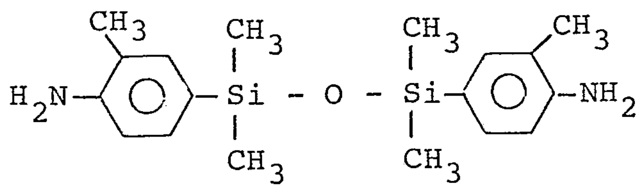

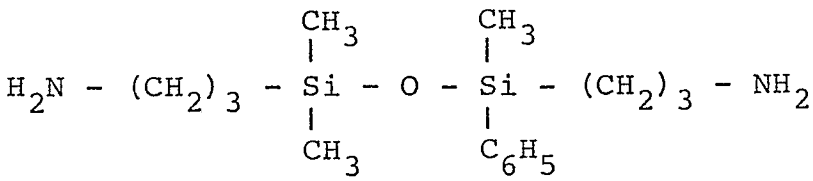

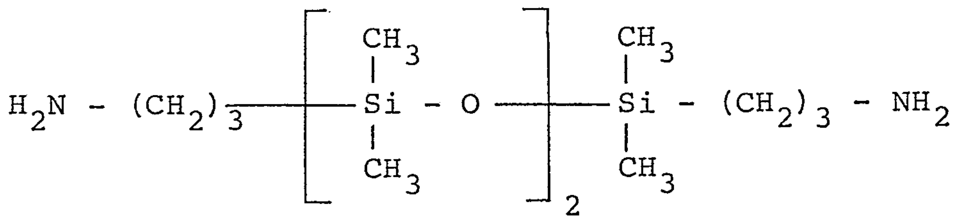

These compounds can be used alone or as a mixture thereof.

The polyamide-acid can be synthesized by reacting a tetracarboxylic acid dianhydride and a diamine in a solvent. The reaction is preferably carried out under anhydrous conditions and at a temperature of 50°C or lower. It is preferable to use the tetracarboxylic acid dianhydride and the diamine in about equimolar amounts.

The reaction of a tetracarboxylic acid with a diamine can be carried out in a mixed solvent of an organic polar solvent (ii-a) and an organic ketone solvent (ii-b). Alternatively, the reaction can be carried out in an organic polar solvent to give a polyamide-acid, followed by mixing and dilution with an organic ketone solvent.

As the organic polar solvent (ii-a), there can be used N-methyl-2-pyrrolidone, N,N-dimethylacetamide, N,N-dimethylformamide, N,N-diethylformamide, N-vinylpyrrolidone, γ-butyrolactone, etc.

As the organic solvent of ketone (ii-a) represented by the formula:

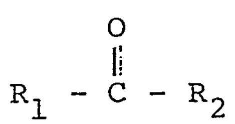 (I)

wherein $R_1$ and $R_2$ are independently an alkyl group having 1 to 8 carbon atoms, there can be used ethyln-butyl ketone, diisobutyl ketone, methyl n-amyl ketone, di-n-propyl ketone, diisopropyl ketone, methyl n-butyl ketone, etc. Among them, the use of diisobutyl ketone is preferable.

The proportion of the organic ketone solvent in a total weight of the solvents (ii-a) and (ii-b) is preferably 5 to 50% by weight, more preferably 20 to 30%.

It is also possible to dissolve a diamine in a mixed solvent of a polar solvent (ii-a) and a ketone (ii-b), to add a tetracarboxylic acid dianhydride thereto, followed by the reaction at preferably 50°C or lower, more preferably near room temperature or lower with stirring to give a polyamide-acid.

The thus obtained polyamide-acid is stirred in the mixed solvent of (ii-a) and (ii-b) at a temperature preferably 50 to 80°C for adjusting a viscosity suitable for use. Preferable viscosity is 5 to 50 poises. Further, a preferable solid content is 50% by weight or less.

The thus obtained composition is suitable for coating on semiconductor elements by a potting treatment using a syringe vessel. The composition is usually filled in the syringe vessel and allowed to stand at room temperature for 30 to 60 minutes. Bubbles in the composition can be removed sufficiently by vacuum defoaming. Then, the syringe vessel is connected to a dispenser using an adapter and a gas pressure is adjusted to a predetermined value by passing, for example, nitrogen to carry out a potting treatment of a semiconductor element. The coating amount is, for example, preferably 45 to 55 mg in the case of a

semiconductor element of 4.0 mm long and 13.0 mm wide.

After the potting treatment, the coated semiconductor element is placed in a curing furnace or a warm-air dryer and heated preferably at 100° C for 60 minutes for drying, followed by heating at 230 to 250° C for 30 to 90 minutes for dehydration ring closure to form a polyimide film on the semiconductor element.

In the case of protective films formed by prior art polyimide precursor resin compositions, since wettability is not good, it is impossible to completely cover corner portions of a semiconductor element having an area of 60 $mm^2$ using 50 mg of a polyimide precursor resin composition by a potting treatment. In contrast, when the composition of the present invention is used, only 25 mg is sufficient for the potting treatment to completely cover the semiconductor element without pealing due to thermal stress. This means that the composition of the present invention is excellent in wetting and spreading properties.

This invention is illustrated by way of the following Examples in which all percents are by weight unless otherwise specified.

Example 1

To 80 g of a mixed solvent of 64.0 g of N-methyl-2-pyrrolidone and 16.0 g of diisobutyl ketone, 10.7627 g of 2,2′-bis[4-(4-aminophenoxy)phenyl]propane, 0.343 g of 1,3-bis(aminopropyl) tetramethyldisiloxane and 8.8943 g of 3,3′,4,4′-benzophenone tetracaboxylic dianhydride were added and reacted at 25° C for 4 hours. Then, the reaction solution was stirred at 80° C for 9 hours to adjust a viscosity to 40 poises and to obtain a composition having a solid content of 20%.

The composition was filled in a cleaned syringe vessel and allowed to stand at room temperature for 30 minutes. Then, the syringe was connected to a dispenser (ML-505, a trade name, mfd. by Musashi Engineering Co., Ltd.) with a connecting adapter. A semiconductor element (4.5 mm x 13.0 mm) was subjected to a potting treatment under nitrogen gas pressure therein. With 15 mg of the composition, a wetting and spreading distance of 13 mm was obtained in the longer direction of the semiconductor element, and with 25 mg of the composition, corner portions of the semiconductor element were completely covered.

After potting treatment, the semiconductor element was allowed to stand in an atmosphere of 60% humidity and 23° C for 30 minutes, placed in an over at 100° C for 60 minutes in a nitrogen atmosphere, followed by a heat treatment at 250° C for 60 minutes to form a polyimide resin surface protective film on the semiconductor element.

As mentioned above, this composition was wet spreaded completely to the corner portions of the semiconductor element. Further, the resulting protective film was not pealed off from the interface of the semiconductor element even if the protective film was compulsorily scratched with a metallic pin. This means that the adhesiveness is very good.

Example 2

A composition was prepared by reacting 2,640 g of p-phenylenediamine, 2.095 g of 4,4′-diaminodiphenyl ether and 10.265 g of 3,3′,4,4′-biphenyl tetracarboxylic dianhydride in 85 g of a mixed solvent of 68 g of N-methyl-2-pyrrolidone and 17 g of methyl n-amyl ketone at 25° C for 6 hours, and stirring at 80° C for 8 hours to adjust the viscosity to 50 poises, the solid content being 15%.

Using this composition, the potting treatment was carried out in the same manner as described in Example 1. Then, the coated semiconductor element was placed in an oven and dried at 100° C for 60 minutes, followed by the heat meatment at 200° C for 30 minutes and further at 350° C for 60 minutes to form a polyimide resin surface protective film on the semiconductor element.

The surface protective film showed remarkably good adhesiveness and the composition also showed very good wettability to cover the corner portions of semiconductor element.

Example 3

A composition was prepared by reacting 12.915 g of 2,2′-bis[4-(4-aminophenoxy)phenyl]propane, 0.412 g of 1,3-bis(aminopropyl)tetramethyldisiloxane and 10.6732 g of 3,3′,4,4′-benzophenone tetracarboxylic dianhydride in 76 g of N-methyl-2-pyrrolidone at 25° C for 5 hours, and stirring at 80° C for 8 hours to adjust the viscosity to 140 poises, the solid content being 24%.

To 100 g of the resulting composition, 20 g of di-n-propyl ketone was added and stirred at room temperature for 1 hour for dissolution to give a composition having a viscosity of 40 poises and a solid content of 20%.

This composition was treated in the same manner as described in Example 1 to form a polyimide surface protective film on a semiconductor element. The surface protective film had the same properties as in Example 1.

Comparative Example 1

A composition was prepared by reacting 2.640 g of p-phenylenediamine, 2.095 g of 4,4′-diaminodiphenyl ether and 10.265 g of 3,3′,4,4′-biphenyl tetracarboxylic dianhydride in 85 g of N-methyl-2-pyrrolidone at 25° C for 5 hours, and stirring at 80° C for 8 hours to adjust the viscosity to 40 poises, the solid content being 15%.

Using this composition, the potting treatment was carried out in the same manner as described in Example 1 and the heat treatment was carried out in the same manner as described in Example 2 to form a polyimide resin surface protective film on a semiconductor element.

This composition was insufficient in wetting and spreading properties to cover the corner portions of the

semiconductor element.

Comparative Example 2

A composition was prepared by reacting 8.072 g of 2,2′-bis[4-(4-aminophenoxy)phenyl]propane, 0.257 g of 1,3-bis(aminopropyl)tetramethyldisiloxane and 6.671 g of 3,3′,4,4′-benzophenone tetracarboxylic dianhydride in 85 g of N-methyl-2-pyrrolidone at 25° C for 5 hours and stirring at 80° C for 8 hours to adjust the viscosity to 40 poises, the solid content being 15%.

Using this composition, the potting treatment was carried out in the same manner as described in Example 1. But the composition was insufficient in wetting and spreading properties to cover corner portions of a semiconductor element. Even if the potting amount was increased, no wet spreading to the corner portions was obtained.

Comparative Example 3

A composition was prepared by reacting 10.7627 g of 2,2′-bis[4-(4-aminophenoxy)phenyl]propane, 0.343 g of 1,3-bis(aminopropyl)tetramethyldisiloxane and 8.8943 g of 3,3′,4,4′-benzophenone tetracarboxylic dianhydride in 80 g of a mixed solvent of 56 g of N-methyl-2-pyrrolidone and 24 g of n-butyl Cellosolve acetate at 25° C for 4 hours and stirring at 80° C for 8 hours to adjust the viscosity to 40 poises, the solid content being 20%.

Using this composition, the potting treatment was carried out in the same manner as described in Example 1. In order to obtain the wet spreading distance of 13 mm in the longer direction of a semiconductor element, 25 mg of the composition was necessary. Further, in order to cover corner portions of the semiconductor element completely, the coating amount should be increased to 55 mg. This means that this composition is insufficient in wettability.

As mentioned above, according to the composition for forming a protective film of semiconductor elements of this invention, since the composition is remarkably excellent in wettability, a uniform thin polyimide resin film can be formed on a semiconductor element having wiring of leading out leads by means of metallic fine wires, even if a small coating amount is used.

Thus, semiconductor devices wherein polyimide protective films are formed on semiconductor elements such as MOS memories, CCD, etc., are especially useful as a large-sized element necessitating shielding of alpha rays.

**Claims**

1. A composition for forming a protective film on a semiconductor element comprising
   i) a polyamide-acid reaction product of a tetra-carboxylic acid anhydride and a diamine,
   (ii-a) an organic polar solvent, and
   (ii-b) as an organic solvent, a ketone of the formula (I)

$$R_1 - \overset{\overset{\displaystyle O}{\|}}{C} - R_2 \qquad (I)$$

wherein $R_1$ and $R_2$ are the same or different and each is alkyl having 1 to 8 carbon atoms.

2. A composition according to claim 1, wherein the ketone organic solvent is contained in an amount of 5 to 50% by weight.

3. A composition according to claim 1 or claim 2 wherein the organic polar solvent is at least one of N-methyl-2-pyrrolidone, N,N-dimethylacetamide and N,N-dimethylformamide.

4. A composition according to any one of claims 1 to 3 wherein the ketone of the formula (I) is at least one of ethyl n-butyl ketone, diisobutyl ketone, methyl n-amyl ketone, di-n-propyl ketone, diisopropyl ketone and methyl n-butyl ketone.

5. A composition according to claim 4, wherein the ketone of the formula (I) is diisobutyl ketone.

6. A composition according to any one of claims 1 to 5 wherein the polyamide-acid is obtainable by reacting a tetracarboxylic acid dianhydride with a diamine in a mixed solvent comprising
   (ii-a) an organic polar solvent, and
   (ii-b) a ketone of the formula (I) as defined in claim 1.

7. A process for producing any one of claims 1 to 6 comprising reacting a tetra-carboxylic acid dianhydride with a diamine in at least one solvent selected from (ii-a) and organic polar solvent and (ii-b) a ketone of the formula (I) as defined in claim 1 to form a polyamide-acid.

8. Use of a composition according to any one of claims 1 to 6 or produced according to claim 7 in production of a protective coating on a surface of a semiconductor element.

9. A process for producing a semiconductor device comprising coating a surface of a semiconductor element with a composition according to any one of claims 1 to 6 or produced according to claim 7 followed by heat treatment.

10. A semiconductor device including a semiconductor element having a surface coated with a protective film obtainable from a composition according to any one of claims 1 to 6 or produced according to claim 7.